# EUROPEAN PATENT APPLICATION

(11) **EP 1 081 755 A2**
(43) Date of publication of application: **07.03.2001**
(21) Application number: 00115048.1
(22) Date of filing: 26.07.2000
(51) Int. Cl.: H01L 21/316

(54) **Method for improving a quality of dielectric layer and semiconductor device**

(30) Priority: 01.09.1999 JP 24772799
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Suzuki, Setsu, Semiconductor Process Lab. Co.,Ltd., Tokyo 108-0075 (JP); Maeda, Kazuou, Semiconductor Process Lab. Co.,Ltd., Tokyo 108-0075 (JP)
(74) Representative: Schwabe - Sandmair - Marx

(57) **Abstract**

There is provided a film quality improving method for an insulating film, which comprises the steps of forming a silicon oxide film (105) on a substrate (101), and applying heat treatment to the silicon oxide film (105) by exposing a surface of the silicon oxide film (105) to a steam-containing atmosphere after the silicon oxide film (105) is formed.

## Description

### BACKGROUND OF THE INVENTION

The present invention relates to a film quality improving method for an insulating film and a semiconductor device and, more particularly, a film quality improving method for an SiO₂ film for densifying the SiO₂ film by reducing impurities such as hydrocarbon, etc., which are contained in the SiO₂ film (insulating film) formed by the CVD (Chemical Vapor Deposition) method using a reaction gas containing TEOS (Tetraethoxysilane), and a semiconductor device.

In the prior art, after the insulating film such as the SiO₂ film, etc. is formed on a substrate such as a silicon wafer, etc., heat treatment called annealing is applied to the insulating film. This heat treatment is performed for the purpose of improving the film quality of the insulating film. This heat treatment is performed by exposing the surface of the insulating film to the high temperature atmosphere containing an inert gas such as N₂, etc.

### SUMMARY OF THE INVENTION

It is an object of the present invention to provide a novel film quality improving method for an insulating film that is different from the heat treatment using N₂ (nitrogen), and a semiconductor device manufactured by using the same.

In the film quality improving method for the insulating film according to the present invention, the heat treatment is performed by exposing the surface of the SiO₂ film (insulating film), which is formed by the CVD (Chemical Vapor Deposition) method using a reaction gas containing TEOS (Tetraethoxysilane), to the atmosphere containing steam. According to this method, steam or OH group dissociated from the steam enters into the inside of the SiO₂ film, then impurities such as hydrocarbon, etc. contained in the film are oxidized to desorb to the outside of the film. At the same time, dangling bonds of Si (silicon) atoms contained in the film are replaced with SiO₂ bonds by a strong oxidizing tendency of the steam-containing atmosphere.

According to the measurement performed by the inventors of the present invention, it has been found that, if the heat treatment is performed in such manner, the SiO₂ film whose film quality is close to the thermal oxide film can be obtained at the lower temperature compared with the heat treatment in the N₂ (nitrogen) atmosphere. The reason for this may be considered that the desorption of the above impurities and replacement of dangling bonds of the Si (silicon) atoms with the SiO₂ bonds can be achieved at the relatively low temperature. Therefore, since the heat treatment is performed at the lower temperature compared with the heat treatment in the N₂ (nitrogen) atmosphere, the device failure due to the heat treatment at the high temperature atmosphere is prevented.

Also, according to other measurement performed by the inventors of the present invention, it has been found that the effect of the film quality improvement reaches not only an upper layer portion of the SiO₂ film but also an almost 1.0 µm depth from a surface of the film. Therefore, the film quality improvement of the SiO₂ film that is formed in the deep trench, for example, can also be attained.

In addition, according to still other measurement performed by the inventors of the present invention, it has been found that change in the film thickness after the heat treatment is smaller than the heat treatment in the N₂ (nitrogen) atmosphere. It may be considered as the reason for this that new SiO₂ is formed on the side wall portions and the bottom portions of the deep trenches of the film by thermally oxidizing Si (silicon) layers and thus shrinkage of the film can be suppressed by an amount of such newly formed SiO₂. Therefore, the device failure due to the shrinkage of the film can be prevented.

### BRIEF DESCRIPTION OF THE DRAWINGS

FIGS.1A to 1G are sectional views showing a film quality improving method for an insulating film according to an embodiment of the present invention;
FIG.2 is a graph showing a relationship between a heat treatment temperature of an SiO₂ film, to which the film quality improving method for the insulating film is applied, and a wet etching rate ratio of the SiO₂ film to a thermal oxide film;
FIG.3 is a graph showing a relationship between a depth from a surface of the SiO₂ film, to which the film quality improving method for the insulating film is applied, and the wet etching rate ratio of the SiO₂ film to the thermal oxide film at this depth;
FIG. 4 is a graph showing a relationship between the heat treatment temperature of the SiO₂ film, to which the film quality improving method for the insulating film is applied, and change of a film thickness; and
FIGS.5A, 5B and FIG.6 are sectional views showing problems in a film quality improving method for an insulating film according to comparative examples.

### DETAILED DESCRIPTION OF THE PREFERRED EMBODIMENT

An embodiment of the present invention will be explained in detail with reference to the accompanying drawings hereinafter.

### (1) Explanation of the film quality improving method for an insulating film according to the present embodiment

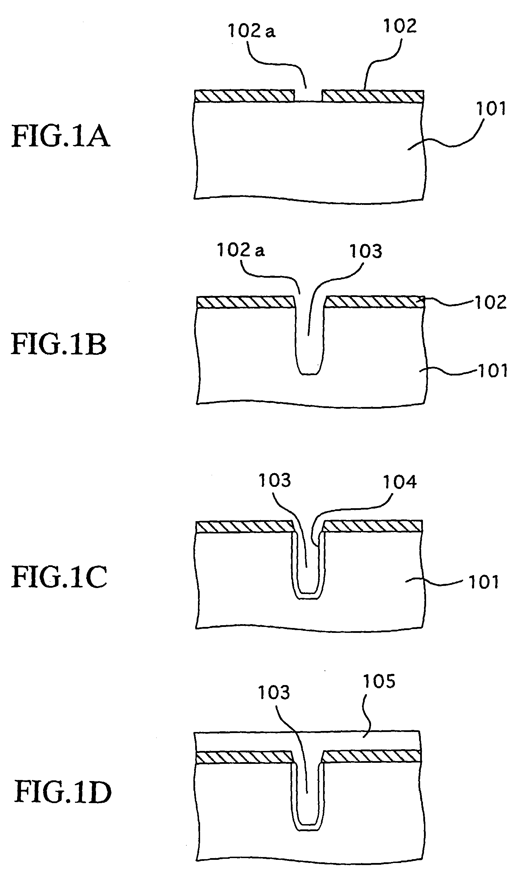

FIGS.1A to 1G are sectional views showing the film quality Improving method for the insulating film according to the present embodiment.

The film quality improving method for the insulating film according to the present invention will be explained with reference to steps of burying a STI (Shallow Trench Isolation) structure for device isolation as an example.

First, as shown in FIG.1A, an SiN film 102 having an opening portion 102a is formed on a surface of a wafer (silicon single crystal) 101 that is a substrate.

Then, as shown in FIG.1B, the dry etching is performed by using the SiN film 102 as a mask. Accordingly, the wafer (silicon single crystal) 101 located directly under the opening portion 102a is selectively etched, whereby a trench 103 is formed.

In turn, as shown in FIG.1C, a thermal oxide film 104 is formed in the trench 103 by exposing the wafer (silicon single crystal) 101 to the high temperature oxygen atmosphere.

Then, as shown in FIG.1D, an SiO₂ film (insulating film) 105 is formed on an overall surface. This SiO₂ film 105 is formed by the atmospheric pressure CVD (atmospheric pressure Chemical Vapor Deposition) method containing TEOS and a high concentration O₃ in a reaction gas. It has been known that, if O₃ is added to the reaction gas at a relatively high concentration, the formed SiO₂ film 105 exhibits a surface flowability (also referred to as a "flow characteristic" hereinafter).

It is considered that this flow characteristic is caused since a great number of polymers of TEOS molecules (also referred to as "TEOS oligomers" hereinafter) are formed in forming the film on the substrate such as the silicon wafer, etc. and then the TEOS oligomers flow on the surface of the silicon wafer.

Then, because of the flow characteristic, insides of trenches 103 are filled completely with the SiO₂ film 105 without any unfilled spaces. Film forming conditions for the SiO₂ film 105 are listed on Table 1.

**Table 1**

| Items | Condition Values |
|---|---|
| Wafer temperature | 415 °C |
| O₂ flow rate | 7.5 slm |
| N₂ flow rate | 18.0 slm |
| TEOS/N₂ flow rate | 7.5 slm |
| O₃ concentration | 130 g/Nm³ |
| Deposited film thickness | 1.2 µm |

In the present embodiment, TEOS is supplied to a chamber (not shown) by means of N₂ bubbling. The "TEOS/N₂ flow rate" on the fifth line of Table 1 is defined as the flow rate of N₂ used in this bubbling. The "N" in the unit "g/Nm³" on the sixth line of Table 1 is an abbreviation for "Normal (standard state)", and this unit "g/Nm³" is defined as a density in the standard state (0 °C, 1 atmospheric pressure).

Also, instead of using the atmospheric pressure CVD method which employs reaction gas containing TEOS and high concentration O₃, if subatmospheric pressure CVD method or low pressure CVD method employing the same reaction gas are used to form the SiO₂ film 105, results obtained in the following are similar.

AS described above, the impurities such as hydrocarbon, etc. are contained in the SiO₂ film 105 formed by the CVD method using the reaction gas containing TEOS. Such impurities exert a bad influence upon the characteristic of the semiconductor device. Therefore, the impurities such as hydrocarbon, etc. in the SiO₂ film 105 must be reduced to improve the film quality.

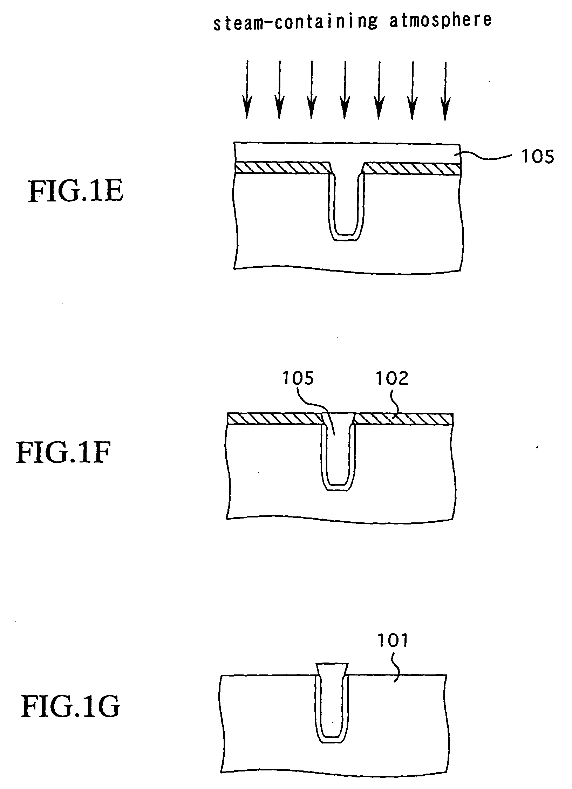

To accomplish this, as shown in FIG.1E, a heat treatment is performed for the SiO₂ film 105. This heat treatment is carried out by exposing the surface of the SiO₂ film 105 to the steam-containing atmosphere.

In the present embodiment, in order to set the chamber (not shown), in which the heat treatment is performed, to the steam-containing atmosphere, the oxygen and the hydrogen are supplied to the chamber to react with each other (hydrogen burning method). The heat treatment conditions (temperature, oxygen flow rate, and hydrogen flow rate) at this time and the film quality of the SiO₂ film 105 after the film quality improvement will be described later. If the steam is supplied to the chamber by bubbling the water in place of the above hydrogen burning method, results obtained in the following are similar.

Then, as shown in FIG.1F, after the heat treatment is finished in this manner, the SiO₂ film 105 on the surface of the SiN film 102 is removed by polishing a surface of the SiO₂ film 105 by means of the CMP (Chemical Mechanical Polishing) method.

Finally, as shown in FIG.1G, the SiN film 102 formed on the surface of the wafer (silicon single crystal) 101 is removed, whereby the STI structure burying steps have been completed.

### (2) Comparative example

The film quality of the SiO₂ film 105 which has been subjected to the heat treatment performed in the steam- containing atmosphere, as shown in FIG.1E, will be explained hereunder based on various measurements carried out by the inventors of the present invention. In particular, such film quality will be explained while comparing with the case where the heat treatment is performed by using N₂ (nitrogen).

In order to evaluate the film quality of the SiO₂ film 105 after the film quality is improved, the inventors of the present invention investigated (I) a relationship between the heat treatment temperature and a wet etching rate ratio of the SiO₂ film 105 to the thermal oxide film, (II) a relationship between a depth from the surface of the SiO₂ film 105 and the wet etching rate ratio of the SiO₂ film 105 to the thermal oxide film at this depth, and (III) a relationship between the heat treatment temperature of the SiO₂ film 105 and change in the film thickness.

### (I) Relationship between the heat treatment temperature and the wet etching rate ratio of the SiO₂ film 105 to the thermal oxide film

The wet etching rate ratio of the SiO₂ film 105 to the thermal oxide film is defined as (wet etching rate of the SiO₂ film 105)/(wet etching rate of the thermal oxide film). This wet etching rate ratio serves as a criterion to decide to what extent the film quality of the SiO₂ film 105 is made close to that of the thermal oxide film.

More particularly, if dangling bonds of the Si-O bond or impurities such as hydrocarbon, etc. are contained in the film, the wet etching rate ratio of the film is increased by them and therefore the wet etching rate ratio to the thermal oxide film is increased. In contrast, if dangling bonds or the impurities are contained in the film with a small amount, the wet etching rate of the film comes close to that of the thermal oxide film and therefore the wet etching rate ratio to the thermal oxide film comes close to 1. Hence, if the wet etching rate ratio to the thermal oxide film is closer to 1, a smaller amount of dangling bonds and the impurities are contained in the film, and therefore the film quality comes close to that of the thermal oxide film.

By the way, it may be considered that, if the wafer is placed in the high temperature atmosphere, the lattice defect is induced in the Si (silicon) crystal due to the stress caused by the bowing of the wafer and thus the device failure is caused. For this reason, it is preferable that the above heat treatment should be performed at low temperature as possible.

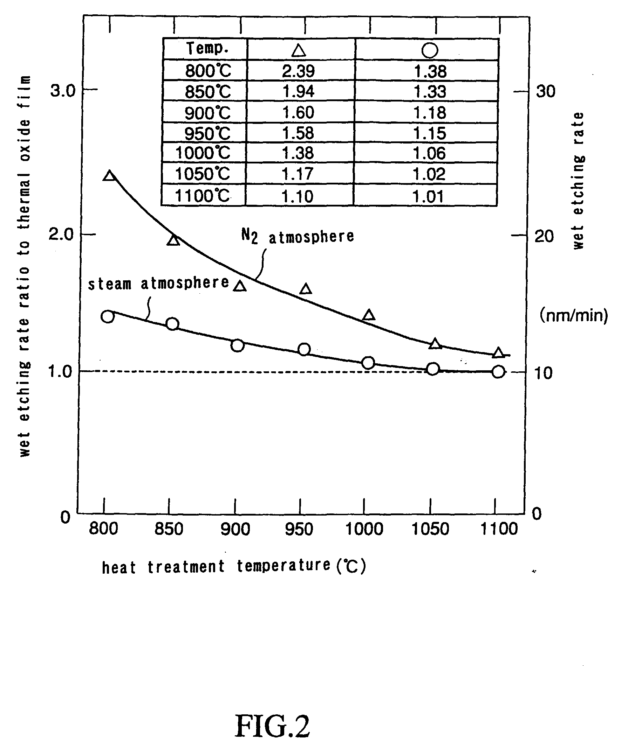

FIG.2 is a graph showing the relationship between the heat treatment temperature and the wet etching rate ratio of the SiO₂ film 105 to the thermal oxide film. The film forming conditions of the SiO₂ film 105 at this time are given in Table 1. The 2 % hydrofluoric acid buffer solution is employed as the etchant. In FIG.2, the results obtained when the heat treatment is performed in the N₂ (nitrogen) atmosphere are also depicted for comparison. The heat treatment conditions at this time are as shown in Table 2. The wet etching rate ratios are measured when the heat treatment temperature is set to 800 °C, 850 °C , 900 °C, 950 °C , 1000 °C , 1050 °C , and 1100 °C respectively.

**Table 2**

| Items | Condition Values | |
|---|---|---|
| | N₂ atmosphere (Comp. example) | Steam-containing atmosphere (Present invention) |
| N₂ flow rate | 10.0 slm | ------ |
| H₂ flow rate | ------ | 6.0 slm |
| O₂ flow rate | ------ | 8.0 slm |
| Heat treatment Temperature | 800 °C, 850 °C, 900 °C, 950 °C, 1000 °C, 1050 °C, 1100 °C | |
| Heat treatment Time | 30 min | |

As is evident from FIG.2, in the heat treatment performed in the N₂ atmosphere, the wet etching rate ratio cannot become smaller than 1.1 after the heat treatment of 1100 °C. On the contrary, if the heat treatment is performed in the steam-containing atmosphere as is the present invention, the wet etching rate ratio becomes 1.06 , which is smaller than 1.1, after the heat treatment of 1000 °C which is lower than 1100 °C.

Accordingly, it can be understood based on the above results that, if the film quality improving method for the insulating film according to the present invention is applied, it is possible to bring the film quality of the SiO₂ film 105 closer to that of the thermal oxide film at the low temperature compared with the case where the heat treatment is performed in the N₂ atmosphere.

The reason for this may be considered as follows. That is, if the steam is contained in the heat treatment atmosphere, an oxidizing tendency of the atmosphere is increased. Thus, because of the increased oxidizing tendency, the impurities such as hydrocarbon, etc. contained in the SiO₂ film 105 are oxidized to become lower molecular weight CO₂. H₂O, etc. and then easily desorb from the film. At the same time, dangling bonds of Si (silicon) atoms existing in the SiO₂ film 105 are perfectly replaced with SiO₂ bonds. Then, it may be considered that, since this replacement can be performed at the relatively low temperature, the film quality of the SiO₂ film 105 can come much more closer to that of the thermal oxide film at the lower temperature than the case where the heat treatment is carried out in the N₂ atmosphere.

In this fashion, if the film quality improving method for the insulating film according to the present invention is applied to the SiO₂ film 105, the film quality of the SiO₂ film 105 can be made closer to that of the thermal oxide film at the lower temperature than the case where the heat treatment using the N₂ (nitrogen) is applied.

### (II) Relationship between the depth from the surface of the SiO₂ film 105 and the wet etching rate ratio of the SiO₂ film 105 to the thermal oxide film at this depth

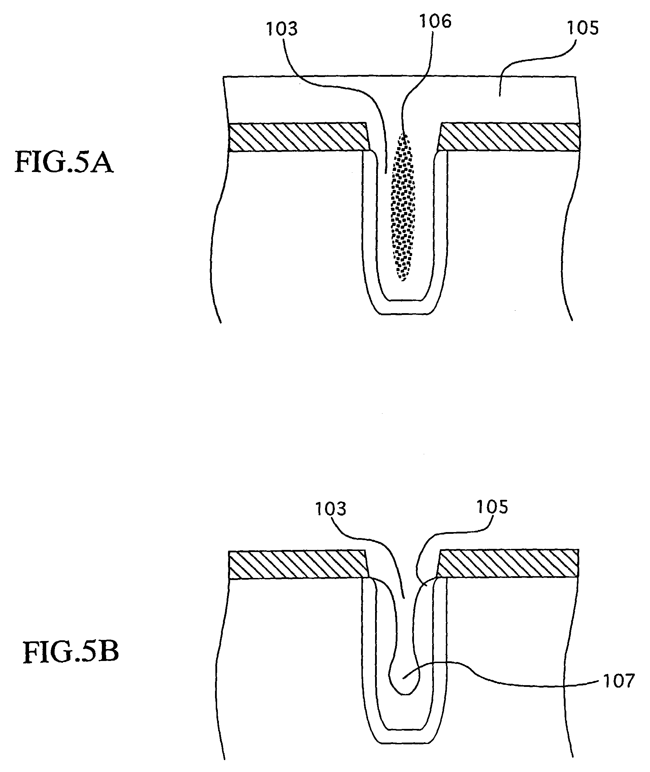

As shown in FIG.5A, the inventors of the present invention have found that, if a width of the trench 103 is narrow, the impurity 106 such as hydrocarbon, etc. is contained considerably in the inside of the SiO₂ film 105 buried in the trench 103 during the step of burying the SiO₂ film 105 (insulating film) into the trench 103 shown in FIG.1D.

This reason may be considered such that, since the step of burying the SiO₂ film 105 into the trench 103 is completed in a short time if the width of the trench 103 is narrow, there is no time for the impurities such as hydrocarbon, etc., that are largely contained in the TEOS molecules constituting the oligomer to desorb from the film.

Therefore, in order to render such impurities to desorb from the film, the inventors of the present invention have applied the heat treatment to the SiO₂ film 105 in the N₂ (nitrogen) atmosphere. As a result, the inventors of the present invention have found that the impurities contained in the deep portion of the trench 103 as described above cannot be reduced sufficiently in the heat treatment using the N₂ (nitrogen). The reason for this may be considered such that, since the N₂ (nitrogen)is not oxidative, the impurity 106 cannot be sufficiently expelled to the outside of the film by the N₂ (nitrogen).

FIG.5B is a sectional view showing experimental results obtained by the inventors of the present invention to verify that the impurities contained in the deep portion of the film cannot be sufficiently reduced in the heat treatment using the N₂ (nitrogen).

FIG.5B shows the situation where the SiO₂ film 105 is exposed to the etchant such as HF (hydrofluoric acid), hydrofluoric acid buffer solution, etc. after the SiO₂ film 105 is subjected to the heat treatment using N₂. As can be seen from FIG.5B, a void 107 is formed in the SiO₂ film 105 formed in the trench 103. This is because the etching rate of the SiO₂ film 105 where the impurity 106 is remained is increased higher than the SiO₂ film 105 where the impurity 106 is not remained and thus a portion of the SiO₂ film 105 where the impurity 106 is contained is apt to be etched.

In order to prevent the above situation, it is preferable that the impurities located not only in the surface layer of the film but also in the deep portion of the film can be reduced by the heat treatment of the SiO₂ film 105.

Therefore, in order to investigate how deeply the film quality improving effect is attained by the film quality improving method of the present invention, the inventors of the present invention have examined a relationship between a depth from the surface of the SiO₂ film 105 and the wet etching rate ratio of the SiO₂ film 105 to the thermal oxide film at this depth.

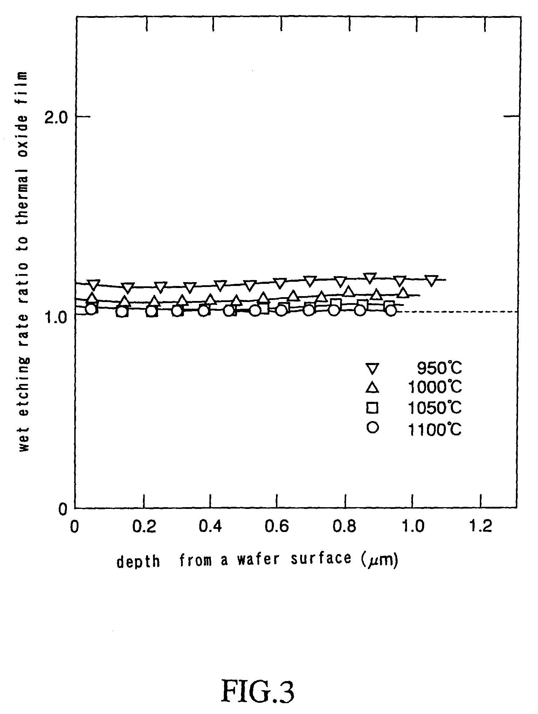

FIG.3 is a graph showing a relationship between the depth from the surface of the SiO₂ film 105 and the wet etching rate ratio of the SiO₂ film 105 to the thermal oxide film at this depth.

As is apparent from FIG.3, it can be understood that the wet etching rate ratio of the SiO₂ film 105 to the thermal oxide film is substantially constant in the depth range of 0.0 µm to 1.0 µm from the surface of the film. This indicates that the film quality improving effect is attained not only in the surface layer portion of the film, but also attained in the whole of the film uniformly.

Based on this result, according to the film quality improving method for the insulating film of the present invention, it can be expected the film quality in the deeper portion of the SiO₂ film 105 can be improved compared with the heat treatment using the N₂ (nitrogen).

### (III) Relationship between the heat treatment temperature of the SiO₂ film 105 and change in the film thickness

Normally, there is a possibility that the insulating film such as the SiO₂ film 105, etc. is thermally shrunken by the heat treatment. This is because the insulating film is densified by the heat treatment and thus the film is shrunken by an amount of increase of the density.

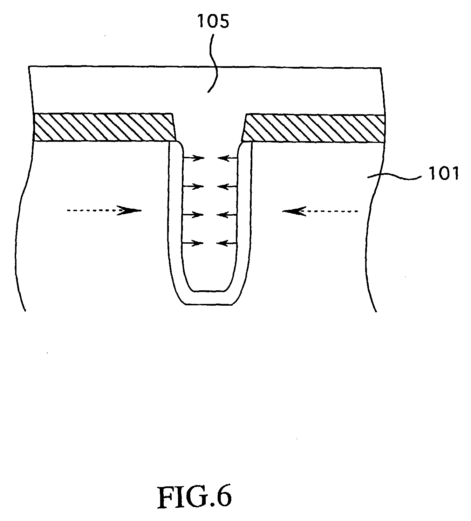

FIG.6 shows the situation of such shrinkage when employing the heat treatment using N₂. In the case of the heat treatment using the N₂ (nitrogen), the SiO₂ film 105 is shrunken along the direction indicated by solid line arrows in FIG.6. Then, the tensile stress is applied to the wafer (silicon single crystal) 101 along the direction indicated by broken line arrows in FIG.6 with the shrinkage of the SiO₂ film 105. This tensile stress causes the crystal defect in the wafer (silicon single crystal) 101 and thus causes the device failure.

For this reason, it is preferable that such thermal shrinkage is suppressed as small as possible. Hence, the inventors of the present invention have examined how the film thickness of the SiO₂ film 105 is changed by the film quality improving method for the insulating film according to the present invention.

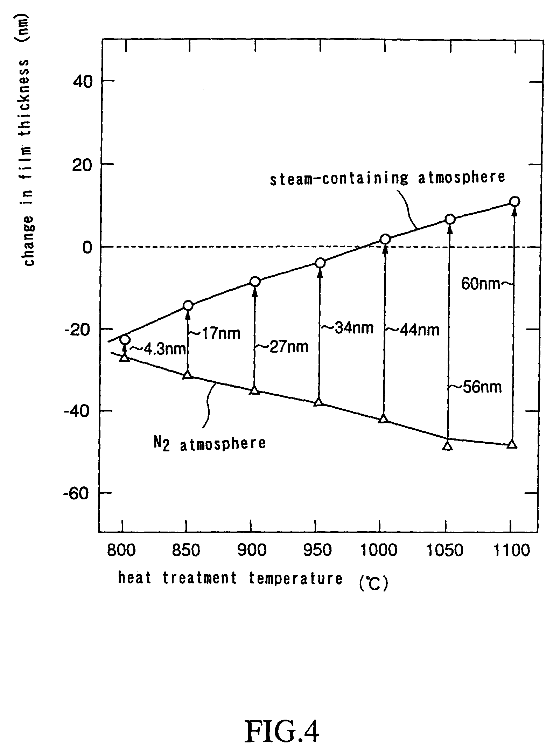

FIG.4 is a graph showing a relationship between the heat treatment temperature of the SiO₂ film 105 and change in the film thickness. In FIG.4, the results obtained when the heat treatment is performed in the N₂ atmosphere are also depicted for the sake of comparison.

As apparent from FIG.4, in the heat treatment in the N₂ atmosphere, the reduction of the film thickness of about 30 nm to 50 nm is found. In contrast, in the present invention (the heat treatment in the steam-containing atmosphere), the reduction of the film thickness of about 1.5 nm is found at 950 °C, and the increase of the film thickness of about 10 nm is found at 1100 °C at which the change in the film thickness is maximum. Hence, it can be understood that, if the film quality improving method for the insulating film according to the present invention is applied, the change in the film thickness of the SiO₂ film 105 can be reduced smaller than the case where the heat treatment in the N₂ atmosphere is applied.

Also, in the heat treatment in the N₂ atmosphere, the change in the film thickness is monotonously reduced as the heat treatment temperature is increased. This is because the film is densified with the increase of the heat treatment temperature and thus the film is shrunken by an amount of the increase of the density.

On the contrary, in the present invention (the heat treatment in the steam-containing atmosphere), the change in the film thickness is monotonously increased with the increase of the heat treatment temperature. The reason for this will be given as follows. That is, Si (silicon) layers on the side wall portion and the bottom portion of the trench 103 are thermally oxidized by the strong oxidizing tendency of the steam-containing atmosphere to generate new SiO₂. Then, since the increase of the film thickness of the SiO₂ film 105 due to the newly generated SiO₂ is larger than the reduction of the film thickness due to the desorption of the impurities such as hydrocarbon, etc., the overall film thickness of the SiO₂ film 105 is increased. In addition, since an amount of the newly generated SiO₂ as explained above is increased if the heat treatment temperature is increased, the change of the film thickness is monotonously increased as a function of the heat treatment temperature.

As shown in FIG.4, if the heat treatment temperature is less than 950 °C, the change of the film thickness of the SiO₂ film 105, to which the film quality improving method for the insulating film according to the present invention is applied, is smaller than zero. It may be considered as the reason for this that the reduction of the film thickness due to the desorption of the impurities is larger than the increase of the film thickness due to the newly generated SiO₂ at this temperature or less.

Also, if the heat treatment temperature is in the neighborhood of 1000 °C, the change of the film thickness of the SiO₂ film 105 becomes almost zero. It may be considered as the reason for this that the reduction of the film thickness due to the desorption of the impurities such as hydrocarbon, etc. and the increase of the film thickness due to the newly generated SiO₂ cancel each other and thus the overall film thickness of the SiO₂ film 105 is not changed.

Therefore, to reduce the device failure due to the change in the film thickness effectively, it is preferable that the improving method of the present invention is performed at the temperature of about 1000°C

In this manner, in the film quality improving method for the insulating film according to the present invention, the change in the film thickness of the SiO₂ film 105 due to the heat treatment can be reduced compared with the heat treatment in the N₂ (nitrogen) atmosphere.

With the above, the film quality improving method according to the present invention is applied to the SiO₂ film which is formed by using the CVD method using TEOS, but the present invention should not be limited to the above. That is, the film quality improving method according to the present invention can also be applied to the silicon oxide film formed by any film forming method.

Also, in the present embodiment, the film quality improving method for the insulating film according to the present invention was explained while taking the steps of burying the STI structure of the semiconductor device as an example. However, the scope in which the present invention can be applied should not be limited to the above. For example, the present invention can be applied to the interlayer insulating film of the semiconductor device, etc.

In addition, although the film quality improving method for the insulating film according to the present invention was explained in the above, the insulating film whose quality is improved by using the improving method of the present invention may be applied to the semiconductor device. In such semiconductor device, since the impurities contained in the insulating film is reduced sufficiently, such a problem seldom occurs that the characteristics of the device are harmfully affected by the impurities. Further, such another problem is hard to occur that the device failure of the semiconductor device is caused by the tensile stress of the insulating film due to the heat treatment.

As mentioned above, according to the film quality improving method for the insulating film of the present invention, following advantages can be achieved by applying the heat treatment in the steam-containing atmosphere to the SiO₂ film, which is formed by the CVD method using the reaction gas containing TEOS.
(1) Compared with the case where the heat treatment is performed in the N₂ atmosphere, the SiO₂ film whose film quality is closer to that of the thermal oxide film can be obtained at the lower temperature.
(2) Compared with the case where the heat treatment is performed in the N₂ atmosphere, it can be expected that the improvement effect in the film quality can be attained in the deeper portion of the film.
(3) Compared with the case where the heat treatment is performed in the N₂ atmosphere, the change in the film thickness can be reduced.

Moreover, if the insulating film that is subjected to the film quality improving method for the insulating film according to the present invention is applied to the semiconductor device, the number of impurities contained in the insulating film as well as the tensile stress caused by the heat treatment can be satisfactorily reduced. As a result, the semiconductor device in which the device failure is seldom caused can be provided.

## Claims

1. A film quality improving method for an insulating film, comprising the steps of:
forming a silicon oxide film (105) on a substrate (101); and
applying heat treatment to the silicon oxide film (105) by exposing a surface of the silicon oxide film (105) to a steam-containing atmosphere after the silicon oxide film (105) is formed.

2. The film quality improving method according to claim 1, wherein the silicon oxide film (105) is formed by a chemical vapor deposition method using a reaction gas containing TEOS (Tetraethoxysilane).

3. The film quality improving method according to any one of claims 1 and 2, wherein the steam is generated by supplying hydrogen and oxygen to the atmosphere.

4. The film quality improving method according to any one of claims 1 and 2, wherein the steam is supplied to the atmosphere by bubbling water.

5. The film quality improving method according to any one of claims 1 to 4, wherein the heat treatment is performed at a temperature in a range of more than 800 °C and less than 1100 °C in the atmosphere.

6. A semiconductor device manufactured by using the film quality improving method set forth in any one of claims 1 to 5.
